# EUROPÄISCHE PATENTSCHRIFT

(11) **EP 2 896 124 B1**
(45) Veröffentlichungstag und Bekanntmachung des Hinweises auf die Patenterteilung: **26.04.2017**
(21) Anmeldenummer: 13753633.0
(22) Anmeldetag: 28.08.2013
(51) Int. Cl.: H02N 2/04, F04B 43/04

(54) **AGGREGAT MIT VIELSCHICHTAKTOR**
ASSEMBLY WITH A MULTILAYER ACTUATOR
GROUPE ÉQUIPÉ D'UN ACTIONNEUR MULTICOUCHES

(30) Priorität: 17.09.2012 DE 102012216564
(43) Veröffentlichungstag der Anmeldung: 22.07.2015
(73) Patentinhaber: Robert Bosch GmbH, 70442 Stuttgart (DE)
(72) Erfinder: DENES, Istvan, 71336 Waiblinge/Hohenacker (DE)
(86) Internationale Anmeldenummer: PCT/EP2013/067808
(87) Internationale Veröffentlichungsnummer: WO 2014/040860

(56) Entgegenhaltungen:
- DE-A1- 19 647 752
- DE-B3- 10 358 818
- DE-C1- 19 525 087
- DE-C1- 19 730 052
- US-A1- 2007 164 641
- US-A1- 2007 251 474
- US-B1- 6 463 982

## Beschreibung

### Stand der Technik

Die Erfindung betrifft ein Aggregat sowie einen Vielschichtaktor, insbesondere zur Verwendung bei einem erfindungsgemäßen Aggregat.

Ein aus einer Vielzahl von übereinander gestapelten Elektrodenschichten ausgebildeter Vielschichtaktor, der zwischen den Elektrodenschichten aus einem dielektrischen Material bestehende, flexible Dielektrikumschichten aufweist, ist aus der DE 10 2008 002 489 A1 der Anmelderin bekannt. Um eine höhere mechanische Beanspruchung des Vielschichtaktors in Zugrichtung zu erreichen, ist es bei dem bekannten Vielschichtaktor vorgesehen, dass die deformierbaren Schichten miteinander und/oder die Elektrodenschichten mit zumindest einer der deformierbaren Schichten vernetzt sind/ist. Derartige Vielschichtaktoren dienen insbesondere der Verstellung bzw. Bewegung von Elementen. Hierbei sind die Vielschichtaktoren beispielsweise mit einem zu verstellenden Element, beispielsweise einer Stange oder ähnlichem, verbunden. Durch Anlegen einer elektrischen Spannung an die Elektrodenschichten wird das Element durch gegenseitige Anziehung der Elektrodenschichten bei gleichzeitiger Ausdehnung der zwischen den Elektrodenschichten angeordneten deformierbaren Schichten bewegt. Darüber hinaus sind auch Anwendungsfälle bekannt, bei denen ein Element mit einem Vielschichtaktor verbunden ist, wobei das Element durch eine äußere Kraft bewegt wird und dabei den Vielschichtaktor deformiert, insbesondere zusammendrückt. Dadurch kann ein Vielschichtaktor als Generator zur Stromerzeugung verwendet werden.

DE 103 58 818 B3, DE 197 30 052 C1, DE 196 47 752 A1 und DE 195 25 087 C1 zeigen piezoelektrische Aktoren, welche ein Betriebsmittel verdrängen, WO 03/081762 A1 zeigt elektroaktive Aktoren.

### Offenbarung der Erfindung

Ausgehend von dem dargestellten Stand der Technik liegt der Erfindung die Aufgabe zugrunde, ein Aggregat unter Verwendung wenigstens eines Vielschichtaktors auszubilden, das sich in vielfältiger Art und Weise verwenden lässt. Dies erfolgt erfindungsgemäß bei einem Aggregat mit den Merkmalen des Anspruchs 1 dadurch, dass der wenigstens eine Vielschichtaktor in Wirkverbindung, insbesondere in direktem Kontakt, mit einem Druckmittel angeordnet ist und dieses bei Betätigung des Vielschichtaktors aus einem radial angeordnetem Arbeitsraum verdrängt. Mittels einer derartigen Ausbildung eines Aggregats lassen sich verschiedenste vorteilhafte Anwendungsfälle realisieren, die sich infolge der Verdrängung des Druckmittels mittels des Vielschichtaktors ergeben. Derartige Anwendungsfälle können beispielsweise, jedoch nicht einschränkend, in der Verwendung des Aggregats zur Verstellung eines Elements mittels eines mit dem Aggregat verbundenen Betätigungselements bestehen, oder aber beispielsweise in der Förderung von Druckmittel, wozu das Aggregat in Form einer Pumpe ausgebildet werden kann.

Vorteilhafte Weiterbildungen des erfindungsgemäßen Aggregats sind in den Unteransprüchen angegeben.

In der Ausgestaltung des Aggregats wird vorgeschlagen, dass der Arbeitsraum begrenzt bzw. gebildet ist durch ein vorzugsweise starres Gehäuse, in dem der Vielschichtaktor angeordnet ist. Mit anderen Worten gesagt bedeutet dies, dass auch das Druckmittel innerhalb des (starren) Gehäuses angeordnet ist. Dadurch lässt sich zum einen ein besonders robuster Aufbau des Aggregats verwirklichen, da das Druckmittel im Gehäuse relativ geschützt angeordnet ist. Zum anderen lässt sich dadurch ein relativ einfacher Aufbau des Vielschichtaktors verwirklichen, da dieser ebenfalls durch das Gehäuse geschützt angeordnet ist.

In einer alternativen oder zusätzlichen Ausgestaltung kann es vorgesehen sein, dass der Arbeitsraum im Vielschichtaktor ausgebildet ist. Eine derartige Ausbildung ermöglicht es, dass beispielsweise ein den Vielschichtaktor umgebendes Gehäuse lediglich dem mechanischen Schutz des Aktors dient, jedoch mit Blick auf das Druckmittel nicht hydraulisch dicht ausgebildet sein muss.

In der Erfindung ist es vorgesehen, dass der Arbeitsraum mit einem Speicherraum für das Druckmittel verbunden ist, und dass die Verbindung zwischen dem Arbeitsraum und dem Speicherraum mittels einer Ventileinrichtung steuerbar ist. Darunter wird insbesondere verstanden, dass mittels der Ventileinrichtung die Verbindung zwischen dem Arbeitsraum und dem Speicherraum geöffnet oder verschlossen werden kann. Durch diese Ausbildung wird eine mechanische Versteifung des Vielschichtaktors bewirkt, so dass dieser beispielsweise sehr hohe Zug- oder Druckkräfte aufnehmen kann, ohne dass der Aktor beschädigt bzw. zerstört wird. Hierzu kann es in einer konkreten Ausgestaltung vorgesehen sein, dass der Vielschichtaktor mit einem Betätigungselement, insbesondere einer Betätigungsstange, zusammenwirkt.

Die Ausgestaltung der Erfindung unter Verwendung einer Betätigungsstange bzw. eines Betätigungselements sieht vor, dass zwei Vielschichtaktoren verwendet werden, deren Arbeitsräume mittels einer ein Sperrelement aufweisenden Verbindung miteinander gekoppelt sind, und dass beide Vielschichtaktoren mit dem Betätigungselement verbunden sind. Eine derartige Ausbildung ermöglicht es, das Betätigungselement in unterschiedliche Richtungen jeweils aktiv zu bewegen, wobei in beide Richtungen Verstellkräfte erzeugt werden können.

Eine weitere Anwendung eines erfindungsgemäßen Aggregats besteht in der Ausbildung einer Pumpe. Hierbei ist es vorgesehen, dass der Arbeitsraum mit einer Leitung verbunden ist, in der ein Abzweig angeordnet ist, der zum einen mit einem Vorratsbehälter für Druckmittel, und zum andern mit einer Druckleitung verbunden ist, und dass in der Verbindung zwischen dem Abzweig und der Druckleitung und zwischen dem Abzweig und dem Vorratsbehälter jeweils eine Ventileinrichtung, insbesondere ein Rückschlagventil, angeordnet ist. Eine derartige Ausbildung ermöglicht es, in einer ersten Phase aus dem Vorratsbehälter das Druckmittel anzusaugen, und in einer zweiten Phase das Druckmittel unter Druckerhöhung in eine Druckleitung zu pumpen.

Ein Vielschichtaktor, insbesondere zur Verwendung bei einem erfindungsgemäßen Aggregat sieht vor, dass der Vielschichtaktor in Längsrichtung des Vielschichtaktors zumindest über eine Teillänge wenigstens einen Längskanal ausbildet, der Teil des Arbeitsraums für ein Druckmittel ist. Eine derartige Ausbildung des Vielschichtaktors ermöglicht es, beim Anlegen einer elektrischen Spannung an die Elektrodenschichten Druckmittel aus dem Längskanal in dem Vielschichtaktor zu verdrängen.

In einer konstruktiven Ausbildung des Vielschichtaktors ist es vorgesehen, dass die Elektrodenschicht aus einem starren Außenring und einem im Außenring zumindest im stromlosen Zustand mit radialem Spalt angeordneten zentralen Bereich besteht, und dass der wenigstens eine Längskanal im zentralen Bereich ausgebildet ist. Dadurch kann sich der zentrale Bereich beim Anlegen einer elektrischen Spannung an der Elektrodenschicht radial nach außen dehnen, ohne dass dabei der Gesamtdurchmesser des Vielschichtaktors sich vergrößert.

Um bei der Fertigung des Vielschichtaktors bzw. der Längskanäle zu verhindern, dass es zu elektrischen Kurzschlüssen zwischen den Elektrodenschichten beim Ausbilden der Längskanäle kommt, ist es darüber hinaus bevorzugt vorgesehen, dass die Elektrodenschicht im zentralen Bereich nicht bis an den Längskanal heranreicht.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1 und Fig. 2: ein erstes erfindungsgemäßes Aggregat in verschiedenen Betriebsstellungen, jeweils im Längsschnitt,
- Fig. 3: ein zweites erfindungsgemäßes Aggregat in einer ersten Betriebsstellung im Längsschnitt,
- Fig. 4: ein Detail des Aggregats gemäß der Fig. 3 im Längsschnitt,
- Fig. 5: das zweite erfindungsgemäße Aggregat gemäß Fig. 3 in einer zweiten Betriebsstellung, ebenfalls im Längsschnitt,
- Fig. 6: ein Detail aus der Fig. 5 in vergrößerter Darstellung im Längsschnitt,
- Fig. 7 und Fig. 8: ein drittes erfindungsgemäßes Aggregat in verschiedenen Betriebsstellungen, jeweils im Längsschnitt,
- Fig. 9 und Fig. 10: einen Querschnitt durch eine Elektrodenschicht bei einem erfindungsgemäßen Aggregat gemäß der Fig. 3 und 5,
- Fig. 11 und Fig. 12: jeweils ein Detail aus der Fig. 9 in Draufsicht und
- Fig. 13 und Fig. 14: ein viertes und fünftes erfindungsgemäßes Aggregat, das jeweils als Pumpe ausgebildet ist, im vereinfachten Längsschnitt.

Gleiche Elemente bzw. Elemente mit gleicher Funktion sind in den Figuren mit den gleichen Bezugsziffern versehen.

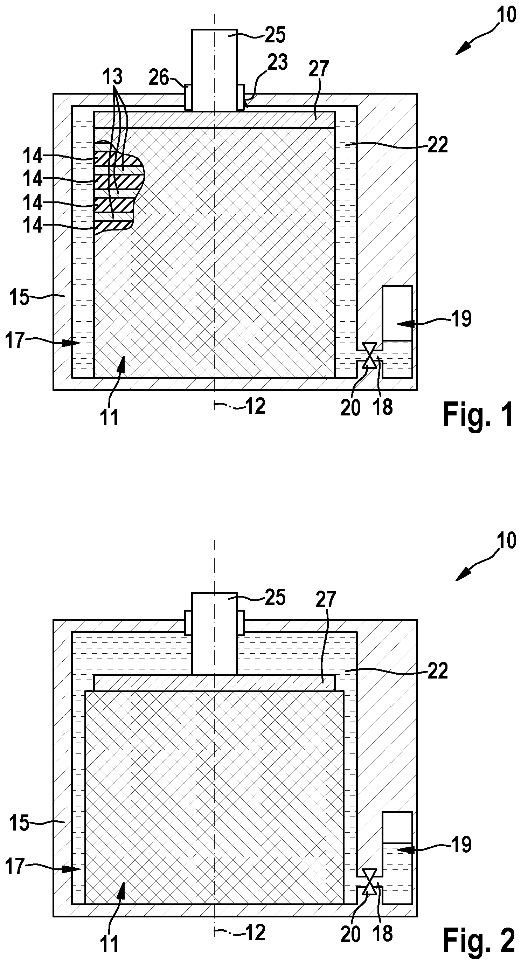

In den Fig. 1 und 2 ist ein erstes erfindungsgemäßes Aggregat 10 dargestellt. Das Aggregat 10 umfasst einen Vielschichtaktor 11, der aus einer Vielzahl von übereinander in Bezug zu einer Längsachse 12 des Vielschichtaktors 11 angeordneten Elektrodenschichten 13 besteht, wobei zwischen zwei Elektrodenschichten 13 jeweils eine aus einem elektrisch nichtleitenden bzw. dielektrischen Material bestehende, elastische Dielektrikumschicht14 angeordnet ist. Üblicherweise sind die Elektrodenschichten 13 als Folienschichten bzw. als Beschichtungen ausgebildet, das bedeutet, dass die Dicke der Elektrodenschichten 13 wesentlich geringer ist als die Dicke der Dielektrikumschicht14. Die Elektrodenschichten 13 sind mit einer nicht dargestellten Spannungsversorgung verbunden.

Der Vielschichtaktor 11 kann entsprechend der DE 10 2008 002 489 A1 der Anmelderin dadurch gekennzeichnet sein, dass die Dielektrikumschichten14 untereinander und/oder die Elektrodenschichten 13 mit zumindest einer der Dielektrikumschichten14 vernetzt sind/ist. Ein soweit bekannter Vielschichtaktor 11 zeichnet sich dadurch aus, dass beim Anlegen einer Spannung an die Elektrodenschichten 13 sich deren gegenseitiger Abstand zueinander infolge der Anziehungskräfte verringert, wobei die zwischen den Elektrodenschichten 13 angeordneten Dielektrikumschichten14 in Querrichtung, d.h. senkrecht zur Längsachse 12, deformiert werden, wobei das Volumen des Vielschichtaktors 11 insgesamt konstant bleibt.

Der Vielschichtaktor 11 ist innerhalb eines vorzugsweise starren Gehäuses 15 mit radialem Abstand zur Wand des Gehäuses 15 angeordnet. Das Gehäuse 15 weist in seinem Inneren einen Arbeitsraum 17 zur Aufnahme des Vielschichtaktors 11, sowie einen von dem Arbeitsraum 17 durch einen Verbindungskanal 18 abgetrennten Speicherraum 19 auf. In den Verbindungskanal 18 ist darüber hinaus eine Ventileinrichtung 20 in Form eines Sperrventils angeordnet. Selbstverständlich liegt es im Rahmen der Erfindung, den Speicherraum 19 außerhalb des Gehäuses 15 in einem separaten Gehäuse oder ähnlichem anzuordnen, und den Speicherraum 19 mit einer entsprechenden Verbindungsleitung mit dem Arbeitsraum 17 zu verbinden.

Innerhalb des Gehäuses 15, insbesondere innerhalb des den Vielschichtaktors 11 umgebenden Bereichs im Arbeitsraum 17 sowie im Speicherraum 19 ist ein Druckmittel 22 angeordnet. Bei dem Druckmittel 22 handelt es sich vorzugsweise um eine (inkompressible) Flüssigkeit, beispielsweise ein Hydrauliköl. An der Oberseite des Gehäuses 15 besitzt dieses einen Durchbruch 23, der von einem Betätigungselement, beispielsweise einer Kolbenstange 25, durchdrungen ist. Der Durchbruch 23 ist zur Kolbenstange 25 hin mittels eines Dichtelements 26 hydraulisch abgedichtet. Die Kolbenstange 25 ist über eine Verbindungsplatte 27, die mit der einen Stirnfläche des Vielschichtaktors 11 fest verbunden ist, mit dem Vielschichtaktor 11 gekoppelt.

In der Fig. 1 ist der Zustand des Vielschichtaktors 11 dargestellt, bei der an den Elektrodenschichten 13 keine Spannung anliegt. Das Druckmittel 22 umgibt den Vielschichtaktor 11 und füllt den Arbeitsraum 17 vollständig aus, während der Speicherraum 19 teilweise mit dem Druckmittel 22 befüllt ist. In der Fig. 2 ist der Zustand des Vielschichtaktors 11 dargestellt, bei dem an den Elektrodenschichten 13 Spannung anliegt. Dadurch ziehen sich die Elektrodenschichten 13 in an sich bekannter Art und Weise gegenseitig an, wodurch die zwischen den Elektrodenschichten 13 befindlichen Dielektrikumschichten14 in einer Richtung quer zur Längsachse 12 deformiert werden. Dadurch findet eine Verkürzung des Vielschichtaktors 11 in Richtung der Längsachse 12 statt, die zur Folge hat, dass die Kolbenstange 25 über die Verbindungsplatte 27 in das Innere des Gehäuses 13 hineingezogen wird. Durch das in den Arbeitsraum 17 hineinragende zusätzliche Volumen der Kolbenstange 25 wird Druckmittel 22 bei geöffneter Ventileinrichtung 20 aus dem Arbeitsraum 17 in den Speicherraum 19 verdrängt. Mittels des Vielschichtaktors 11 lässt sich somit über die Kolbenstange 25 beispielsweise ein Element bewegen bzw. verstellen. Wird nun in der in der Fig. 2 dargestellten Stellung des Vielschichtaktors 11 die Ventileinrichtung 20 geschlossen, so dass kein Druckmittel 22 aus dem Speicherraum 19 in den Arbeitsraum 17 zurückfließen kann, so dann infolge des inkompressiblen Druckmittels 22 im Arbeitsraum 17 über die Kolbenstange 25 eine relativ hohe Druckkraft auf den Vielschichtaktor 11 ausgeübt werden, ohne dass der Vielschichtaktor 11 verformt bzw. beschädigt wird.

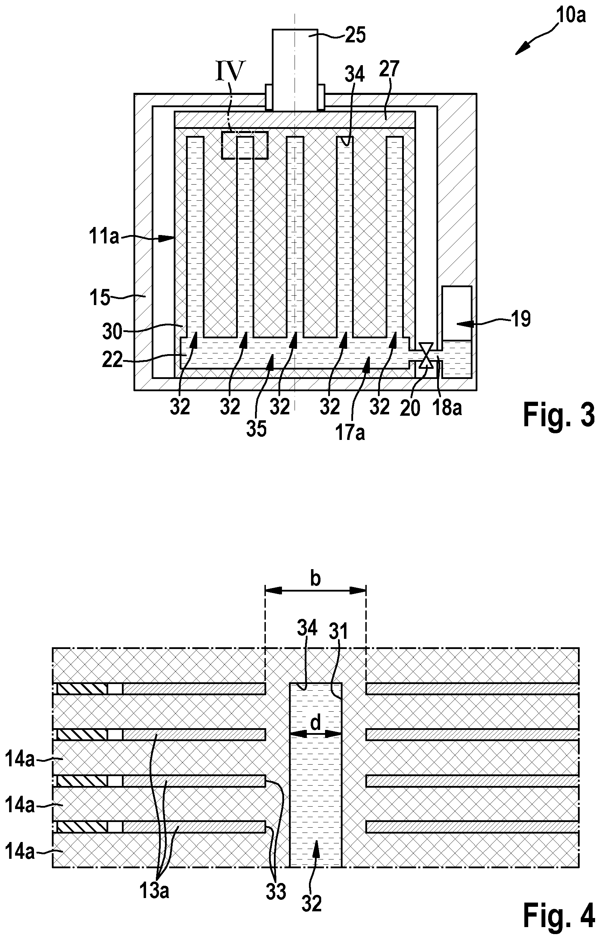

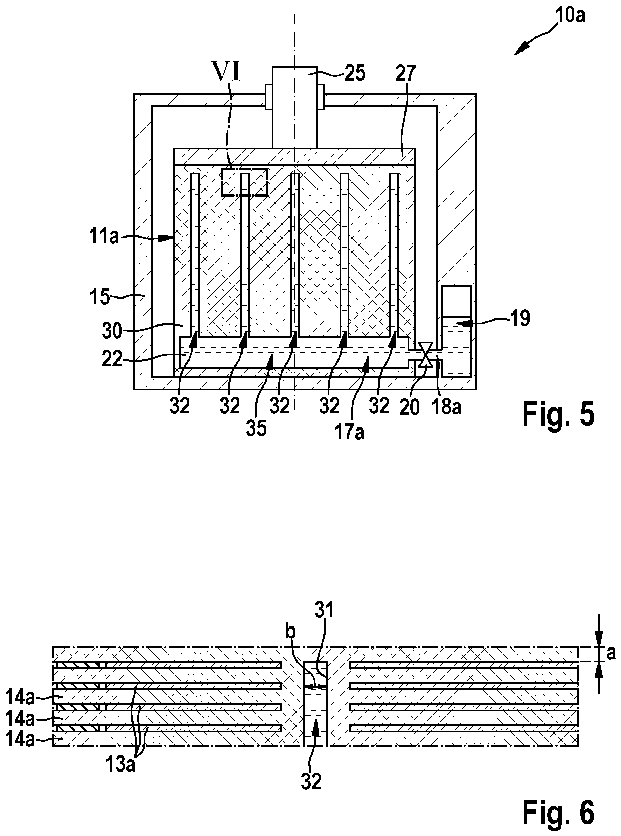

In den Fig. 3 bis 6 ist ein modifiziertes Aggregat 10a dargestellt, das sich von dem Aggregat 10 dadurch unterscheidet, dass der Arbeitsraum 17a zur Aufnahme des Druckmittels 22 innerhalb des Vielschichtaktors 11a ausgebildet ist. Der innerhalb des Gehäuses 15 angeordnete Vielschichtaktor 11a wirkt weiterhin mit einer Kolbenstange 25 zusammen, jedoch ist es, im Gegensatz zum Aggregat 10 nicht erforderlich, das Gehäuse 15 im Bereich der Durchführung der Kolbenstange 25 hydraulisch abzudichten. Der Vielschichtaktor 11a umfasst zur hydraulisch dichten Aufnahme des Druckmittels 22 einen geschlossenen Außenmantel 30, dessen eine Stirnseite in Analogie zu dem Aggregat 10 über die Verbindungsplatte 27 mit der Kolbenstange 25 verbunden ist. Wie insbesondere anhand der Fig. 4 und 6 erkennbar ist, weisen die Dielektrikumschichten14a zueinander fluchtend ausgebildete Öffnungen 31 auf, die in Längsrichtung des Vielschichtaktors 11a verlaufende Längskanäle 32 ausbilden. Die Längskanäle 32 bilden einen Teil des Arbeitsraums 17a aus. Auch die Elektrodenschichten 13a weisen Öffnungen 33 auf, wobei der Durchmesser D der Öffnungen 33 größer ist als der Durchmesser d der Öffnungen 31. Bei dem Herstellungsprozess des Vielschichtaktors 11a kommt es zu einem Vernetzungsprozess des Materials zweier übereiander angeordneter Dielektrikumschichten 14a untereinander, so dass infolge der unterschiedlichen Durchmesser d, D der Öffnungen 31 und 33 die Elektrodenschichten 13a nicht bis an die Längskanäle 32 heranreichen, sondern in ihrem radial inneren Bereich von dem (vernetzten) Material der Dielektrikumschichten14a umgeben sind.

Die Längskanäle 32 sind vorzugsweise über den insbesondere runden Querschnitt des Vielschichtaktors 11a gleichmäßig verteilt, beispielsweise auf einem oder mehreren Lochkreise. Die Längskanäle 32 sind in Art eines Sackloches mit einem Grund 34 auf der der Verbindungsplatte 27 zugewandten Seite ausgebildet. Auf der der Verbindungsplatte 27 abgewandten Seite münden die Längskanäle 32 in einen als Arbeitsraum wirkenden Sammelraum 35 innerhalb des Außenmantels 30 des Vielschichtaktors 11a. Von dem Sammelraum 35 geht wiederum der Verbindungskanal 18a zum Speicherraum 19 ab.

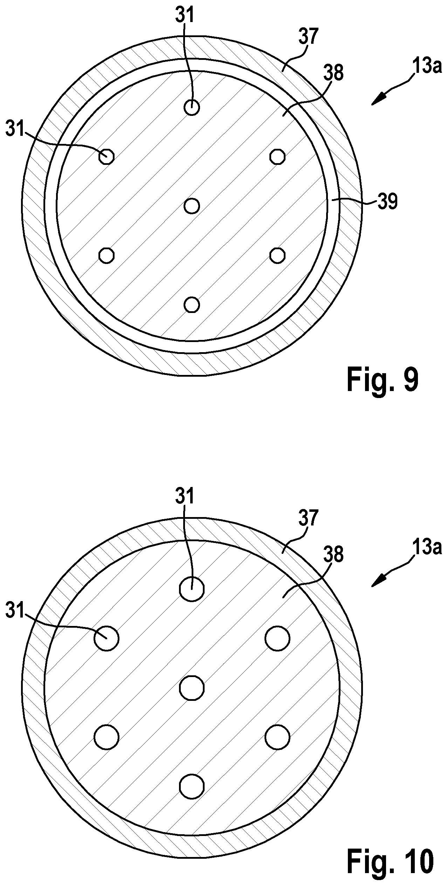

Die Elektrodenschichten 13a des Vielschichtaktors 11a bestehen, wie insbesondere aus einer Zusammenschau der Fig. 9 und 10 erkennbar ist, aus einem starren Außenring 37 und einem radial innerhalb des Außenrings 37 angeordneten, zentralen Bereich 38 aus deformierbarem Material. In der Fig. 9 ist der Zustand des Vielschichtaktors 11 a dargestellt, bei dem an den Elektrodenschichten 13a keine Spannung anliegt. Dabei ist zwischen dem zentralen Bereich 38 und dem Außenring 37 ein Ringspalt 39 ausgebildet. In der Fig. 10 ist demgegenüber der Zustand dargestellt, bei dem an den Elektrodenschichten 13a Spannung anliegt. Hierbei deformiert sich der zentrale Bereich 38, zusammen mit den mit den zentralen Bereichen 38 verbundenen Dielektrikumschichten14a derart, dass sich der Durchmesser des zentralen Bereichs 38 vergrößert und ggf. bis an den Außenring 37 heranragt. Eine weitere Deformation der Elektrodenschichten 13a wird durch die starre Ausbildung des Außenrings 37 verhindert, so dass die Elektrodenschichten 13a, unabhängig davon, ob Spannung an ihnen anliegt oder nicht, insgesamt stets denselben Außendurchmesser aufweisen.

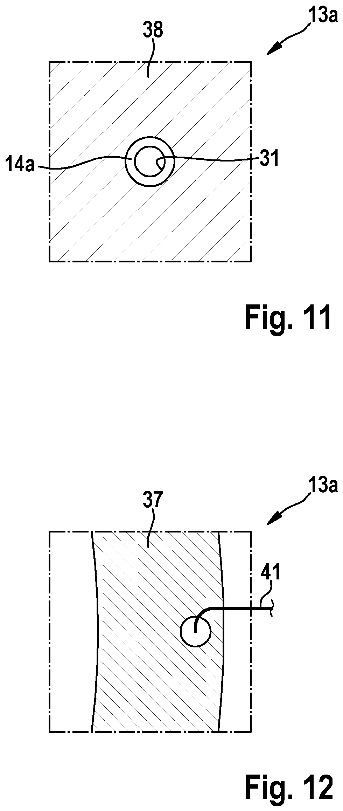

In der Fig. 11 ist darüber hinaus erkennbar, dass die Elektrodenschicht 13a des zentralen Bereichs 38 nicht bis an den Rand der Öffnung 31 der darunter liegenden Dielektrikumschicht 14a heranreicht, sondern zu diesem beabstandet ist. Bei der Herstellung des Vielschichtaktors 11a wird eine Dielektrikumschicht14a in flüssiger Form auf die darunter liegende Dielektrikumschicht14a aufgebracht und in einem sich anschließenden Schritt, ggf. unter Hilfe von UV- oder IR-Strahlung, vernetzt. In der Vernetzungsphase findet eine Haftung zwischen den Dielektrikumschichten 14a statt, wo keine Elektrodenschichten 13a vorhanden sind. Dadurch ist sichergestellt, dass die Öffnungen 31 entsprechend der Darstellung der Fig. 3 und 5, unabhängig davon, ob an den Elektrodenschichten 13a Spannung anliegt, stets aufeinander liegen, und insbesondere dadurch kein Kontakt zwischen dem Druckmittel 22 und den Elektrodenschichten 13a stattfindet.

In der Fig. 12 ist der Außenring 37 bereichsweise dargestellt. Dieser wird insbesondere durch eine Metallisierung ausgebildet. Dadurch, dass der Außenring 37 bei dem Anliegen einer Spannung nicht an einer radialen Ausdehnung teilnimmt, ist der Außenring 37 besonders dazu geeignet, die Stromzuführung über eine Leitung 41 zur Elektrodenschicht 13a aufzunehmen. Weiterhin ist eine nicht dargestellte elektrische Verbindung zwischen dem Außenring 37 und dem Innenring 38 vorgesehen.

Dadurch, dass das Druckmittel 22 nicht mit den Elektrodenschichten 13a in Kontakt gerät, ist es nicht erforderlich, dass das Druckmittel 22 elektrisch nichtleitend ist. Darüber hinaus wird erwähnt, dass eine hohe Dielektrizitätszahl des Druckmittels 22 die Funktion des Vielschichtaktors 11a fördert.

In der Fig. 3 ist der Zustand dargestellt, bei dem an den Elektrodenschichten 13a bzw. dem Vielschichtaktor 11a keine Spannung anliegt. Hierbei weisen die Längskanäle 32 entsprechend der Fig. 4 den Durchmesser d auf. Beim Anlegen einer Spannung an die Elektrodenschichten 13a verringert sich der Durchmesser der Längskanäle 32 entsprechend der Darstellung der Fig. 5 und 6 auf den Durchmesser b, wobei Druckmittel 22 aus den Längskanälen 32 in den Sammelraum 35, und von dort über den Verbindungskanal 18a in den Speicherraum 19 verdrängt wird.

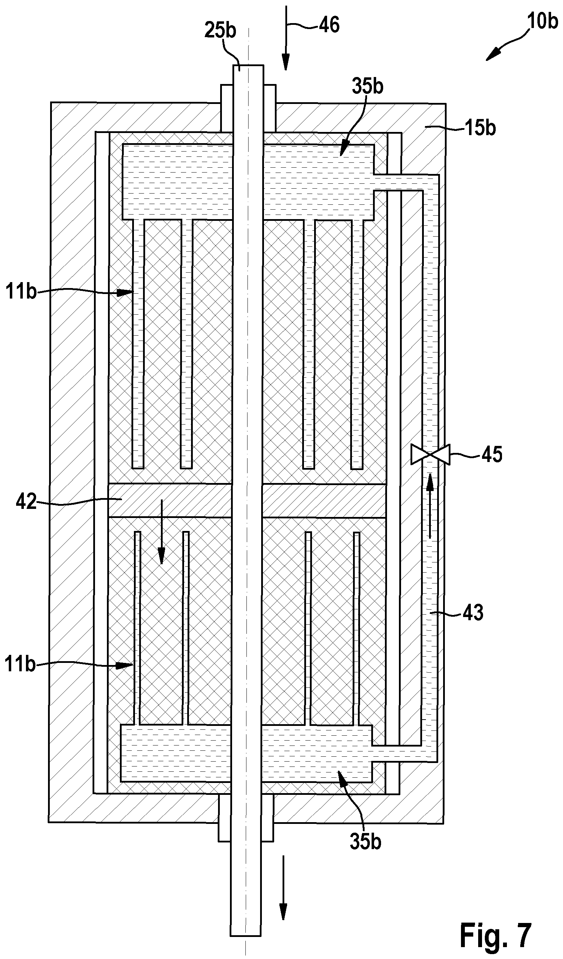

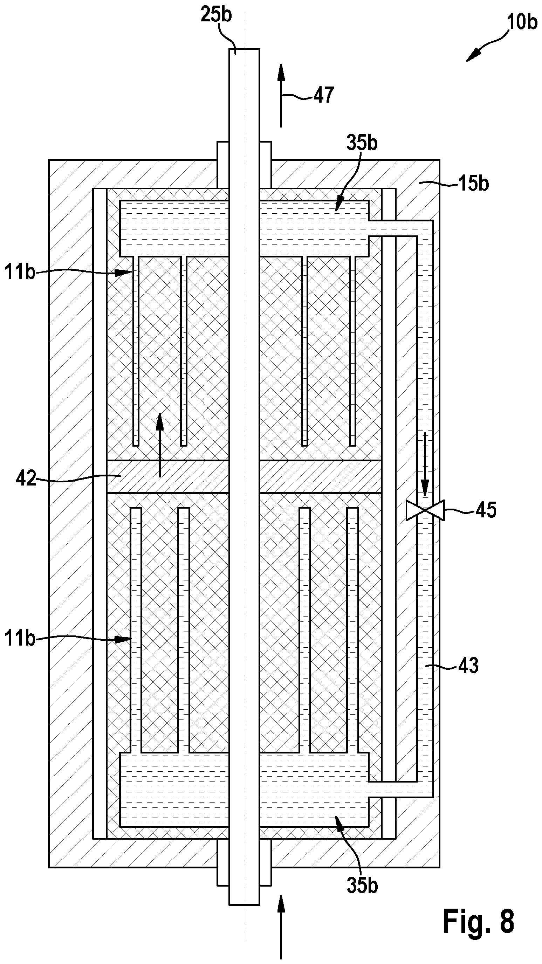

In den Fig. 7 und 8 ist ein weiteres, abgewandeltes Aggregat 10b dargestellt. Das Aggregat 10b unterscheidet sich von den Aggregaten 10 und 10a dadurch, dass das Aggregat 10b zwei Vielschichtaktoren 11b aufweist, die in Längsrichtung aneinander anschließen, und die vorzugsweise jeweils identisch ausgebildet sind. Die beiden Vielschichtaktoren 11b sind wiederum in einem gemeinsamen Gehäuse 15b angeordnet, das, ebenso wie die Vielschichtaktoren 11b, von einem Betätigungselement in Form einer Kolbenstange 25b durchdrungen ist. Die Vielschichtaktoren 11b sind in Analogie zum Vielschichtaktor 11a ausgebildet, wobei diese jedoch in Bezug zu einer Koppelplatte 42 spiegelbildlich zueinander angeordnet sind. Die beiden als Arbeitsräume wirkenden Sammelräume 35b der Vielschichtaktoren 11b sind über einen beispielhaft innerhalb des Gehäuses 15b angeordneten Verbindungskanal 43 miteinander verbunden, wobei im Verbindungskanal 43 eine Ventileinrichtung 45 in Form eines Sperrventils angeordnet ist.

In der Fig. 7 ist der eine Schaltzustand des Aggregats 10b dargestellt, bei dem in der Zeichnungsebene unteren Vielschichtaktor 11b Spannung anliegt, während bei dem in der Zeichnungsebene oberen Vielschichtaktor 11b keine Spannung anliegt. Dadurch wird Druckmittel 22 aus dem Sammelraum 35b des unteren Vielschichtaktors 11b bei geöffneter Ventileinrichtung 45 in den Sammelraum 35b des oberen Vielschichtaktors 11b verdrängt, wobei die Kolbenstange 25b entsprechend des Pfeils 46 nach unten bewegt wird. Wird in der in der Fig. 7 dargestellten Stellung die Ventileinrichtung 45 geschlossen, so kann über die Kolbenstange 25b eine entgegen der Richtung des Pfeils 46 wirkende Zugkraft aufgenommen werden, ohne dass der untere Vielschichtaktor 11b sich deformiert bzw. beschädigt wird.

Zum Bewegen der Kolbenstange 25b in die entgegengesetzte Richtung entsprechend des Pfeils 47 der Fig. 8 wird an den in der Zeichnungsebene oberen Vielschichtaktor 11b Spannung angelegt, während der in der Zeichnungsebene untere Vielschichtaktor 11b spannungslos geschaltet wird. Dadurch wird Druckmittel aus dem Sammelraum 35b des oberen Vielschichtaktors 11b in den Sammelraum 35b des unteren Vielschichtaktors 11b verdrängt.

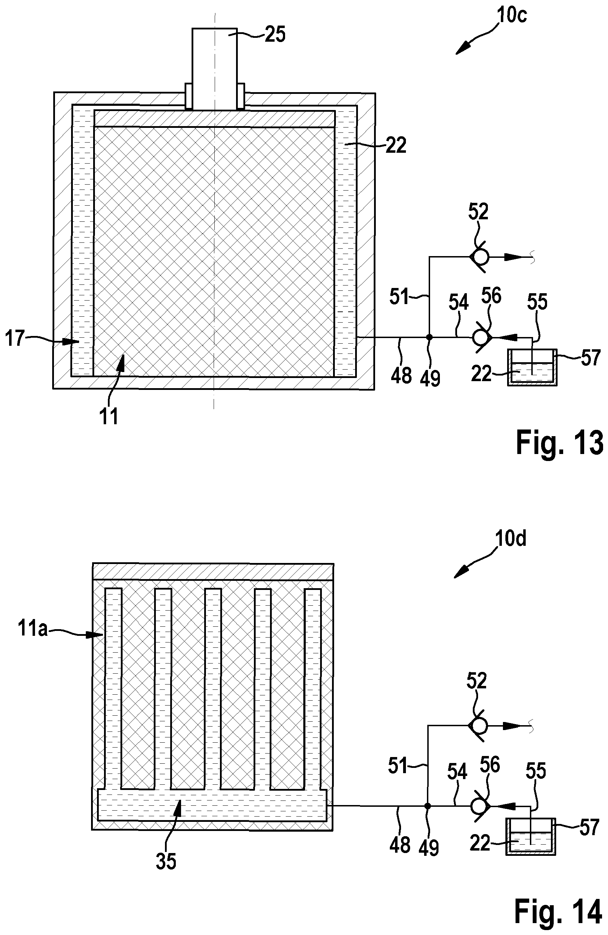

In der Fig. 13 ist ein weiteres erfindungsgemäßes Aggregat 10c dargestellt. Das Aggregat 10c weist eine Pumpenfunktion auf bzw. ist als Pumpe ausgebildet. Das Aggregat 10c unterscheidet sich von dem Aggregat 10 entsprechend der Fig. 1 und 2 dadurch, dass der Arbeitsraum 17 über eine Leitung 48 mit einem Abzweig 49 verbunden ist, der in zwei Richtungen führt. Der eine Zweig 51 ist über ein Rückschlagventil 52 mit einer Druckleitung 53 verbunden. Demgegenüber ist der andere Zweig 54 über eine Ansaugleitung 55 und ein dazwischen geschaltetes Rückschlagventil 56 mit einem Vorratsbehälter 57 für das Druckmittel 22 verbunden. In der in der Fig. 13 dargestellten Stellung des Aggregats 10c liegt an dessen Vielschichtaktor 11 keine Spannung an. Der Arbeitsraum 17 ist vollständig mit Druckmittel 22 befüllt. Das Rückschlagventil 56 sperrt, während das Rückschlagventil 52, das mit der Druckleitung 53 verbunden ist, geöffnet ist. Wird nun an den Vielschichtaktor 11 Spannung angelegt, so wird Druckmittel 22 aus dem Arbeitsraum 17 und die Leitung 48 in die Druckleitung 53 gefördert. Nach Ende der Förderung bzw. beim Unterbrechen der Spannungsversorgung des Vielschichtaktors 11 sperrt das Rückschlagventil 52, während über das Rückschlagventil 56 und die Ansaugleitung 55 Druckmittel 22 aus dem Vorratsbehälter 57 in den Arbeitsraum 17 gefördert wird. Beim nachfolgenden Wiederanlegen der Spannung an den Vielschichtaktor 11 wird das zuletzt aus dem Vorratsbehälter 57 geförderte Druckmittel 22 wiederum in die Druckleitung 53 gefördert.

Zuletzt ist in der Fig. 14 ein gegenüber der Fig. 13 nochmals modifiziertes Aggregat 10d dargestellt, das sich von dem Aggregat 10c entsprechend der Fig. 13 dadurch unterscheidet, dass ein Vielschichtaktor in 11a entsprechend der Fig. 3 bis 6 verwendet wird. Bei dem Aggregat 10d ist somit, im Gegensatz zum Aggregat 10c kein separates Gehäuse 15 erforderlich.

Die soweit beschriebenen Aggregate 10, 10a bis 10d können in vielfältiger Art und Weise abgewandelt bzw. modifiziert werden, ohne vom Erfindungsgedanken abzuweichen. Dieser besteht darin, den jeweils verwendeten Vielschichtaktor 11, 11a und 11b in zumindest mittelbarem Kontakt mit einem Druckmittel 22 anzuordnen, derart, dass beim Anlegen einer Spannung an den Vielschichtaktor 11, 11a, 11b Druckmittel 22 aus dem Arbeitsraum 17, 17a bzw. dem Sammelraum 35, 35b verdrängt wird. So ist es beispielsweise möglich, durch die Kapazitätsänderung der Vielschichtaktoren 11, 11a, 11b Informationen über deren Deformation und dadurch über die Position der Kolbenstange 25, 25b zu erhalten. Eine derartige Konfiguration kann dann zum Beispiel dazu verwendet werden, einen geschlossenen Regelkreis für einen Servo-Aktor oder für eine aktiv regelnde Stoßdämpferanwendung zu realisieren.

## Patentansprüche

1. Aggregat (10; 10c), umfassend wenigstens einen Vielschichtaktor (11), der wenigstens zwei Elektrodenschichten (13) aufweist, zwischen denen eine aus einem elektrisch nichtleitenden Material bestehende, elastische Dielektrikumschicht (14) angeordnet ist, wobei der Vielschichtaktor (11) in direktem Kontakt mit einem Druckmittel (22) angeordnet ist und dieses bei Betätigung des Vielschichtaktors (11) aus einem Arbeitsraum (17) verdrängt, wobei der Arbeitsraum (17) durch ein starres Gehäuse (15) begrenzt bzw. gebildet ist, in dem der Vielschichtaktor (11) angeordnet ist, wobei der Arbeitsraum (17) mit einem Speicherraum (19) für das Druckmittel (22) verbunden ist, wobei die Verbindung zwischen dem Arbeitsraum (17) und dem Speicherraum (19) mittels einer Ventileinrichtung (20), insbesondere mittels eines Sperrventils, steuerbar ist, wobei der Vielschichtaktor (11) mit einem Betätigungselement (25), insbesondere einer Betätigungsstange, verbunden ist, wobei der Vielschichtaktor (11) mit radialem Abstand zur Wand des Gehäuses (15) angeordnet ist, und wobei der den Vielschichtaktor (11) umgebende Bereich im Gehäuse (15) den Arbeitsraum (17) ausbildet.

2. Aggregat nach Anspruch 1,
**dadurch gekennzeichnet,**
**dass** der Arbeitsraum (17) mit einer Leitung (48) verbunden ist, in der ein Abzweig (49) angeordnet ist, der zum einen mit einem Vorratsbehälter (57) für Druckmittel (22), und zum andern mit einer Druckleitung (53) verbunden ist, und dass in der Verbindung zwischen dem Abzweig (49) und der Druckleitung (53) und zwischen dem Abzweig (49) und dem Vorratsbehälter (57) jeweils eine Ventileinrichtung (52, 56), insbesondere ein Rückschlagventil, angeordnet ist.

## Claims

1. Assembly (10; 10c) comprising at least one multi-layer actuator (11) which has at least two electrode layers (13) between which there is arranged an elastic dielectric layer (14) composed of an electrically non-conductive material, wherein the multi-layer actuator (11) is arranged in direct contact with a pressure medium (22) and displaces the latter out of a working chamber (17) in the event of actuation of the multi-layer actuator (11), wherein the working chamber (17) is delimited or formed by a rigid housing (15) in which the multi-layer actuator (11) is arranged, wherein the working chamber (17) is connected to a storage chamber (19) for the pressure medium (22), wherein the connection between the working chamber (17) and the storage chamber (19) is controllable by means of a valve device (20), in particular by means of a shut-off valve, wherein the multi-layer actuator (11) is connected to an actuation element (25), in particular to an actuation rod, wherein the multi-layer actuator (11) is arranged with a radial spacing to the wall of the housing (15), and wherein that region in the housing (15) which surrounds the multi-layer actuator (11) forms the working chamber (17).

2. Assembly according to Claim 1,
**characterized**
**in that** the working chamber (17) is connected to a line (48) in which there is arranged a branch (49) which is connected both to a reservoir (57) for pressure medium (22) and to a pressure line (53), and in that in each case one valve device (52, 56), in particular a check valve, is arranged in the connection between the branch (49) and the pressure line (53) and between the branch (49) and the reservoir (57).

## Revendications

1. Groupe (10 ; 10c) comprenant au moins un actionneur multicouche (11) qui présente au moins deux couches d'électrodes (13) entre lesquelles est disposée une couche de diélectrique élastique (14) constituée d'un matériau non conducteur de l'électricité, l'actionneur multicouche (11) étant disposé en contact direct avec un fluide de pression (22) et repoussant celui-ci hors d'un espace de travail (17) lors de l'actionnement de l'actionneur multicouche (11), l'espace de travail (17) étant limité ou formé par un boîtier fixe (15) dans lequel est disposé l'actionneur multicouche (11), l'espace de travail (17) étant connecté à un espace d'accumulateur (19) pour le fluide de pression (22), la connexion entre l'espace de travail (17) et l'espace d'accumulateur (19) pouvant être commandée au moyen d'un dispositif de soupape (20), en particulier au moyen d'une soupape d'arrêt, l'actionneur multicouche (11) étant connecté à un élément d'actionnement (25), en particulier une tige d'actionnement, l'actionneur multicouche (11) étant disposé à distance radiale de la paroi du boîtier (15) et la région entourant l'actionneur multicouche (11) dans le boîtier (15) constituant l'espace de travail (17).

2. Groupe selon la revendication 1,
**caractérisé en ce que**
l'espace de travail (17) est connecté à une conduite (48) dans laquelle est disposé un branchement (49) qui est connecté d'une part à un réservoir (57) pour le fluide de pression (22) et d'autre part à une conduite de pression (53), et **en ce que** dans la connexion entre le branchement (49) et la conduite de pression (53) et entre le branchement (49) et le réservoir (57) est à chaque fois disposé un dispositif de soupape (52, 56), en particulier un clapet antiretour.
